# EUROPÄISCHE PATENTSCHRIFT

(11) **EP 0 706 211 B1**
(45) Veröffentlichungstag und Bekanntmachung des Hinweises auf die Patenterteilung: **01.12.2004**
(21) Anmeldenummer: 95115305.5
(22) Anmeldetag: 28.09.1995
(51) Int. Cl.: H01L 21/768, H01L 23/528

(54) **Anschlussstruktur für Doppelschichten**
Connection structure for bilayers
Structure de connections pour couches doubles

(30) Priorität: 05.10.1994 DE 4435585
(43) Veröffentlichungstag der Anmeldung: 10.04.1996
(73) Patentinhaber: Micronas GmbH, 79108 Freiburg (DE)
(72) Erfinder: Zimmer, Hans-Günter, Dipl.-Phys. Dr., D-79211 Denzlingen (DE)
(74) Vertreter: Göhring, Robert

(56) Entgegenhaltungen:
- EP-A- 0 488 546
- EP-A- 0 524 818
- EP-A- 0 573 169
- JP-A- 63 152 150
- US-A- 4 849 804
- US-A- 4 900 695
- US-A- 5 252 520
- ROBERT M. GEFFKEN: "Multi-Level Metallurgy for Master Image Structured Logic" IEDM TECHNICAL DIGEST, Bd. 25, Nr. 1, 1983, Seiten 542-545, XP002046462

## Beschreibung

Die Erfindung betrifft eine Anschlußstruktur für Doppelschichten aus z.B. Polysilizium, wie sie in integrierten Halbleiterschaltkreisen vielfach Verwendung findet.

Eine solche Anschlußstruktur ist aus der JP-A-63 152 150 bekannt.

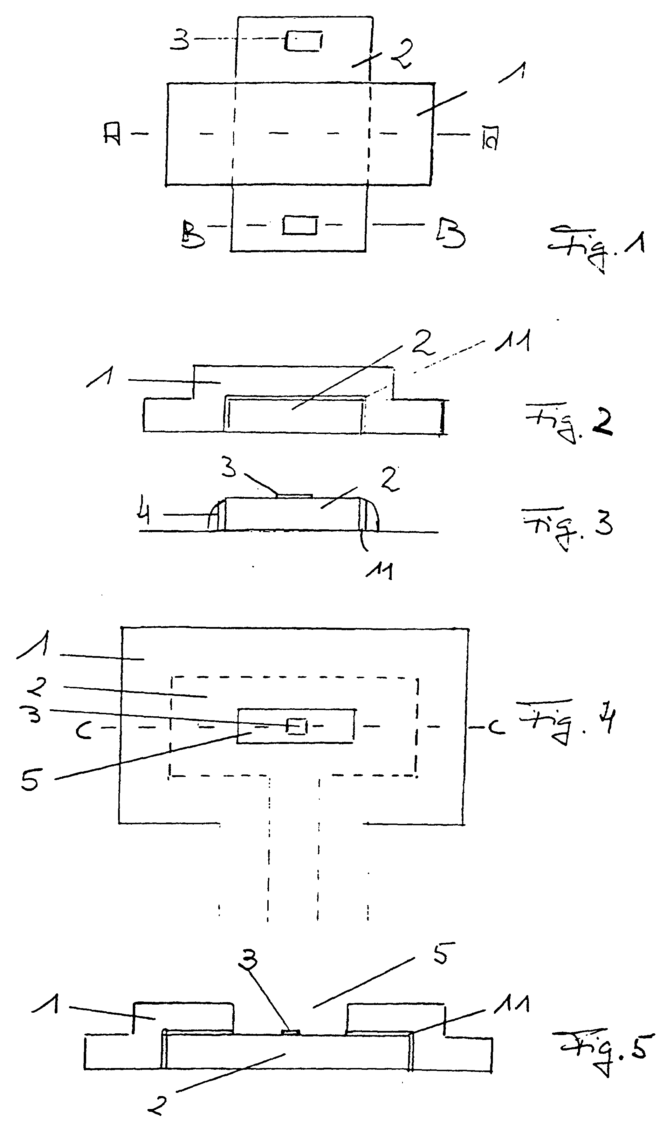

In der Praxis wird dabei üblicherweise die untere Schicht in der in Fig. 1 gezeigten Weise angeschlossen. Die Herstellung derartiger sich überlappender Schichten erfolgt üblicherweise durch ganzflächiges Aufbringen des entsprechenden Materials, z.B. Polysilizium, und anschließender Strukturierung mittels Photolithographie. Zwischen den Schichten wird dabei zweckmäßigerweise ein Dielektrikum angeordnet.

Beim Ätzvorgang im Rahmen des Photolithographieverfahrens zur Erzeugung der oberen Schicht 1 treten dabei an der unteren Schicht 2 sogenannte Spacer auf. Dies erklärt sich aus der Tatsache, daß im Bereich der Kanten der unteren Schicht 2 die obere Schicht 1 in doppelter Dicke geätzt werden muß. Dadurch bleiben bei hinreichend anisotroper Ätzung Spacer 4 an den Seitenflächen der unteren Schicht 2 stehen. Wird nun, was häufig geschieht, ein schwer schmelzendes Metall zur Ausbildung eines Silicids aufgesputtert, um eine Verbesserung der elektrischen Eigenschaften der Anordnung zu erreichen, so kann es in Folge der Spacer zu Kurzschlüssen zwischen oberer Schicht 1 und unterer Schicht 2 kommen.

Der Erfindung liegt die Aufgabe zugrunde, die Anschlußstruktur so auszubilden, daß keine unerwünschten elektrischen Eigenschaften auftreten können. Diese Aufgabe wird mittels der im Anspruch 1 gekennzeichneten Erfindung gelöst.

Die Erfindung wird nun anhand der Figuren 1 bis 5 der beigefügten Zeichnung näher erläutert, wobei diese ausschnittsweise zwei überkreuzende Doppelschichten auf einer Halbleiterstruktur zeigt.
Fig. 1 zeigt den Stand der Technik in der Draufsicht,
Fig. 2 zeigt den Schnitt längst der Linie A-A in Fig. 1,
Fig. 3 zeigt den Schnitt längst der Linie B-B in Fig. 1,
Fig. 4 zeigt die Draufsicht auf die Anschlußstruktur nach der vorliegenden Erfindung, und
Fig. 5 zeigt den Schnitt längst der Linie C-C in Fig. 4.

Der in Fig. 1 gezeigte Stand der Technik läßt erkennen, daß die untere Schicht 2 von der oberen Schicht 1 überlagert wird, wobei die Anschlußkontakte 3 für die untere Schicht 2 im seitlichen Abstand zur Schicht 1 angeordnet sind und eine Isolierschicht die beide Schichten 1; 2 trennt.

Fig. 2 zeigt den Schnitt längst der Linie A-A in Fig. 1. Neben der oberen Schicht 1 und der darunterliegenden unteren Schicht 2 erkennt man das zwischen den beiden Schichten angeordnete Dielektrikum 11, welches die beiden Schichten gegeneinander isoliert. Bei ausreichend dünner Ausbildung desselben ergibt sich eine Kapazitätsstruktur.

In der Fig. 3 ist der Schnitt B-B durch die untere Schicht 2 gezeigt. Man erkennt dabei die auf der Oberfläche der Schicht 2 angeordneten Kontakte 3 sowie die an ihren Flanken vorhandenen Spacer 4. Die Bildung dieser Spacer 4 geht auf das Herstellungsverfahren zurück. Zunächst wird dabei mittels herkömmlicher Photolithographie die untere Schicht 2 erzeugt. Im nächstem Schritt erfolgt dann ebenfalls mit Hilfe der Photolithographietechnik die Bildung der oberen Schicht 1. Dabei wird zunächst die gesamte Oberfläche des Bauelements beschichtet und dann die obere Schicht 1 entsprechend anisotrop herausgeätzt, wobei im Bereich außerhalb der späteren oberen Schicht 1 die gesamte Abdeckung abgeätzt werden müssen, also die Summe der Dicken von Schicht 1 und Schicht 2. Da aber nur weniger als die Summe der Dicke 1 und 2 geätzt wird, kommt es zur Ausbildung der Spacer 4. Im Verlauf des weiteren Aufbaus des Bauelements überbrücken Silicidkörper die isolierende Zwischenschicht 11 ganz oder teilweise, so daß es zu Kurzschlüssen oder elektrischen Oxiddurchbrüchen kommen kann.

Fig. 4 stellt die Draufsicht auf die Anschlußstruktur nach der Erfindung dar. Im Gegensatz zum Stand der Technik wird hier die untere Schicht 2 vollständig von der oberen Schicht 1 abgedeckt. Um den Kontakt 3 an der unteren Schicht 2 anbringen zu können, wird in der oberen Schicht 1 eine Öffnung 5 durch z.B. Ätzen erzeugt. Da hier nur die einfache Schichtdicke geätzt wird, bleiben keine Spacer zurück.

Fig. 5 zeigt den Schnitt durch C-C in Fig. 4, neben den bereits dort beschriebenen Merkmalen ist zusätzlich noch die Isolierschicht (Dielektrikum 11) zu erkennen.

Die erfindungsgemäße Struktur besitzt somit den Vorteil, daß dort, wo die oberen Schicht 1 zu ätzen ist, die zu ätzende Schichtdicke der einfachen Schichtdicke entspricht, so daß Spacer vollständig vermieden werden.

## Patentansprüche

1. Integrierter Halbleiterschaltkreis mit einer Anschlussstruktur für zwei übereinanderliegende elektrisch leitende Schichten (1, 2), wobei eine obere leitende Schicht (1) eine untere leitende Schicht (2) vollständig überdeckt und zwischen der oberen und der unteren Schicht (1, 2) ein die untere Schicht (2) vollständig überdeckendes Dielektrikum (11) ausgebildet ist, und in dem die untere Schicht (2) überdeckenden Bereich der oberen leitenden Schicht (1) und des Dielektrikums (11) wenigstens eine Öffnung (5) zum Anbringen eines Kontaktes (3) auf der unteren leitenden Schicht (2) vorgesehen ist, wobei der Kontakt (3) im inneren Bereich der Öffnung (5) auf der unteren Schicht (2) sitzt und von der oberen Schicht (1) isoliert und beabstandet umgeben ist,
**dadurch gekennzeichnet, dass** der Kontakt (3) auch vom Dielektrikum (11) beabstandet umgeben ist, und dass die obere Schicht (1) und das Dielektrikum (11) eine gleiche gemeinsame und zur Oberfläche der unteren Schicht (2) verlaufende Kante aufweisen, so dass das Dielektrikum (11) und die obere Schicht (1) im Schnitt gesehen gleich beabstandet zum Kontakt (3) sind.

2. Integrierter Halbleiterschaltkreis nach Anspruch 1,
**dadurch gekennzeichnet, dass** die beiden Schichten aus Polysilizium bestehen.

## Claims

1. An integrated semiconductor circuit having a connecting structure for two electrically conductive layers (1, 2), one lying above the other, wherein an upper conductive layer ((1) completely covers a lower conductive layer (2) and between the upper and the lower layers (1, 2) is constructed a dielectric material (11) that completely covers the lower layer (2), and in the region of the upper conductive layer (1) and of the dielectric material (11) that covers the lower layer (2) is provided at least one opening (5) for mounting a contact (3) on the lower conductive layer (2), wherein the contact (3) is seated in the inner region of the opening (5) on the lower layer (2) and is insulated and surrounded spaced from the upper layer (1),
**characterised in that** the contact (3) is also surrounded spaced from the dielectric material (11),
and **in that** the upper layer (1) and the dielectric material (11) have the same common edge that extends to the surface of the lower layer (2), so that the dielectric material (11) and the upper layer (1) are equally spaced from the contact (3) when seen in section.

2. An integrated semiconductor circuit according to Claim 1,
**characterised in that** the two layers are made from polysilicon.

## Revendications

1. Circuit semi-conducteur intégré comportant une structure de branchement pour deux couches électroconductrices (1, 2) superposées, une couche conductrice supérieure (1) couvrant complètement une couche conductrice inférieure (2), avec un diélectrique (11) recouvrant complètement la couche inférieure (2) prévu entre les couches supérieures et inférieures (1, 2), alors qu'au moins une ouverture (5) est prévue dans la zone de la couche conductrice supérieure (1) et du diélectrique (11) couvrant la couche inférieure (2), pour installer un contact (3) sur la couche conductrice inférieure (2), le contact (33) se trouvant dans la zone intérieure de l'ouverture (5) sur la couche inférieure (2) en étant isolé et écarté de la couche supérieure (1),
**caractérisé en ce que**
le contact (3) est également entouré à distance par le diélectrique (11) et la couche supérieure (1) et le diélectrique (11) ont une arète identique, commune, passant sur la surface supérieure de la couche inférieure (2) pour que vus en coupe, le diélectrique (11) et la couche supérieure (1) soient situés à la même distance du contact (3).

2. Circuit semi-conducteur intégré selon la revendication 1,
**caractérisé en ce que**
les deux couches sont en polysilicium.
